# EUROPEAN PATENT SPECIFICATION

(11) **EP 4 391 506 B1**
(45) Date of publication and mention of the grant of the patent: **26.11.2025**
(21) Application number: 23864153.4
(22) Date of filing: 24.08.2023
(51) Int. Cl.: H04M 1/02, H01R 4/48, H04N 23/57, H05K 1/02, H04N 23/00

(54) **GROUNDING ELASTIC PIECE AND ELECTRONIC DEVICE**
ELASTISCHES ERDUNGSTEIL UND ELEKTRONISCHE VORRICHTUNG
PIÈCE ÉLASTIQUE DE MISE À LA TERRE ET DISPOSITIF ÉLECTRONIQUE

(30) Priority: 26.09.2022 CN 202211171070
(43) Date of publication of application: 26.06.2024
(73) Proprietor: Honor Device Co., Ltd., Shenzhen, Guangdong 518040 (CN)
(72) Inventor: CHENG, Honglin, Shenzhen, Guangdong 518040 (CN); HUANG, Zhixiang, Shenzhen, Guangdong 518040 (CN); TANG, Yangjie, Shenzhen, Guangdong 518040 (CN); YANG, Hongbin, Shenzhen, Guangdong 518040 (CN); LIU, Yang, Shenzhen, Guangdong 518040 (CN)
(74) Representative: Epping - Hermann - Fischer
(86) International application number: PCT/CN2023/114648
(87) International publication number: WO 2024/066827

(56) References cited:
- WO-A1-2022/022643
- CN-A- 108 604 742
- CN-A- 113 259 510
- CN-A- 114 760 407
- CN-A- 115 297 201
- CN-U- 209 691 992
- CN-U- 213 367 941
- CN-U- 216 980 898
- US-A1- 2018 176 351
- US-A1- 2018 176 426
- US-A1- 2020 144 751

## Description

This application claims priority to Chinese Patent Application No. 202211171070.4, filed with the China National Intellectual Property Administration on September 26, 2022 and entitled "GROUNDING SPRING AND ELECTRONIC DEVICE".

### TECHNICAL FIELD

This application relates to the field of electronic product technologies, and in particular, to a grounding spring and an electronic device.

### BACKGROUND

A grounding spring is disposed in an electronic device such as a mobile phone. The grounding spring is configured to ground a camera assembly in the electronic device, that is, connect the camera assembly to a grounding area on a main board in the electronic device, to transmit an electrical signal of the camera assembly to the grounding area, thereby reducing signal interference between the camera assembly and another electronic element in the electronic device, and improving an anti-interference capability of the camera assembly. A grounding spring in a related technology is applicable only to an electronic device in which a distance between a camera assembly and a grounding area is relatively small (approximately less than or equal to 1.6 mm) in a thickness direction of the electronic device. Therefore, a grounding spring that can be applied to an electronic device in which a distance between a camera assembly and a grounding area is relatively large (approximately greater than 1.6 mm) is urgently needed.

US 2018/176426 A1 relates to a bracket assembly in a mobile terminal, the mobile terminal comprising a communication element, an electronic component, a frame, and a metal cover, the bracket assembly comprising: a metal support configured to support the electronic component of the mobile terminal; and a multi-contact spring comprising at least one first pressure contact part, at least one second pressure contact part, at least one first elastic part, at least one second elastic part, and at least one fixing part, wherein the multi-contact spring is fixed to the frame of the mobile terminal by the at least one fixing part, the at least one first elastic part is connected to the at least one first pressure contact part and the at least one fixing part and is configured to provide a first restoring force to the at least one first pressure contact part such that the at least one first pressure contact part abuts against the metal cover of the mobile terminal and is grounded, and the at least one second elastic part is connected to the at least one second pressure contact part and the at least one fixing part and is configured to provide a second restoring force to the at least one second pressure contact part such that the at least one second pressure contact part abuts against the metal support so as to ground the metal support to reduce signal interference of the metal support to the communication element.

US 2018/176351 A1 relates to a bracket assembly comprising: a metal bracket, wherein the metal bracket is configured to support an electronic component in a mobile terminal; at least one spring module, wherein the at least one spring module comprises a fixing portion, a pressing portion, and a elastic portion; the fixing portion is fixed in the mobile terminal and grounded, and the elastic portion connects the pressing portion and the fixing portion; the elastic portion is configured to provide a restoring force to the pressing portion, and press the pressing portion to be in contact with the metal bracket.

### SUMMARY

Embodiments of this application aim to provide a grounding spring and an electronic device, to provide a grounding spring that can be applied to an electronic device in which a distance between a camera assembly and a grounding area is relatively large. Specific technical solutions are as follows:
An embodiment in a first aspect of this application provides a grounding spring. The grounding spring is applied to an electronic device, and the electronic device includes a camera assembly, a camera bracket configured to mount the camera assembly, and a circuit board. The circuit board has a grounding area, and the grounding spring includes:
a body part; and
a grounding part, where the grounding part is located on one side of the body part and is fixedly connected to the body part, a first contact is disposed on the grounding part, and the first contact is configured to be in contact with the grounding area.

A side that is of the body part and that is away from the grounding part is bent to form a first bending part extending in a direction towards to the grounding part, and is bent at an end that is of the first bending part and that is close to the grounding to form a second bending part extending part in a direction away from the grounding part, a first accommodating space is formed between the first bending part and the second bending part, the first accommodating space is configured to accommodate a partial structure of the camera bracket, a second contact is disposed on the second bending part, and the second contact is configured to be in contact with the camera assembly.

**In** some embodiments, the grounding part includes a fastening subpart and an elastic subpart connected to the fastening subpart, the fastening subpart is connected to the body part, the first contact is disposed on the elastic subpart, and the elastic subpart may move in a direction close to or away from the fastening subpart.

**In** some embodiments, the elastic subpart includes:
a first subpart and a second subpart that are integrally connected, where the first subpart is disposed closer to the fastening subpart than the second subpart, the first contact is disposed on a lower surface of the second subpart, and elastic deformation space is formed between the first subpart and the second subpart.

**In** some embodiments, the body part is in a sheet-like structure, and a length direction of the sheet-like structure is consistent with a thickness direction of the electronic device;
the grounding part is located at a first end that is of the body part and that is in the thickness direction of the electronic device, and the first bending part is located at a second end that is of the body part and that is in the thickness direction of the electronic device; and
the fastening subpart is formed by laterally bending the first end of the body part, so that the fastening subpart is perpendicular to the body part.

In some embodiments, a first clamping groove is disposed on the camera bracket;
the second bending part includes: a first contact subpart and a second contact subpart; and
the second contact is disposed on the first contact subpart, a first buckle is disposed on a side that is of the second contact subpart and that is close to the first bending part, and the first buckle is configured to be clamped to the first clamping groove.

In some embodiments, the body part is in a sheet-like structure, and the grounding part and both of the first bending part and the second bending part are respectively located on two sides of the sheet-like structure in a length direction.

In some embodiments, the first bending part includes a first bending section and a second bending section that are connected to each other; the first bending section is formed by laterally bending the side that is of the body part and that is away from the grounding part; and the second bending section is formed by bending, in the direction close to the grounding part, an end that is of the first bending section and that is away from the body part;
the second bending part includes a third bending section and a fourth bending section that are connected to each other; the third bending section is formed by laterally bending, in a direction away from the body part, an end that is of the second bending section and that is away from the first bending section; the fourth bending section is formed by bending, in the direction away from the grounding part, an end that is of the third bending section and that is away from the second bending section; and the second contact is disposed on the fourth bending section; and
the second bending section, the third bending section, and the fourth bending section form the first accommodating space.

In some embodiments, the first contact subpart belongs to the fourth bending section, and the second contact is located at an end that is of the fourth bending section and that is away from the third bending section.

In some embodiments, the second contact subpart belongs to the fourth bending section, and the first contact subpart and the second contact subpart are separated from each other, and are both fixedly connected to the third bending section; and
the first buckle is disposed on a side that is of the second contact subpart and that is close to the second bending section.

In some embodiments, at least one second clamping groove is disposed on the camera bracket; and
at least one second buckle is disposed on a side that is of the body part and that is away from the second bending section, and each second buckle is configured to be clamped to one second clamping groove.

In some embodiments, a first through hole is provided on the body part, and the first through hole extends to the fastening subpart; and
a second through hole is provided at each of a joint of the body part and the first bending part, a joint of the first bending part and the second bending part, and a bending location of the second bending part.

In some embodiments, the grounding spring further includes a lap member, and the lap member is disposed between the grounding area and the grounding part of the grounding spring;
the lap member is in a conductive structure; and
one side of the lap member is directly connected to the grounding area, and the other side of the lap member is directly connected to the first contact of the grounding part.

In some embodiments, a distance between the first contact and the second contact in the thickness direction of the electronic device is greater than a preset size.

In some embodiments, a distance between the first contact and the second contact in the thickness direction of the electronic device is greater than 1.6 mm.

An embodiment in a second aspect of this application provides an electronic device. The electronic device includes a camera assembly, a camera bracket, a circuit board, and any one of the foregoing grounding springs. The camera bracket is configured to mount the camera assembly, and the circuit board has a grounding area.

The grounding spring is connected to the camera bracket, the first contact on the grounding part of the grounding spring is in contact with the grounding area on the circuit board, and the second contact on the second bending part of the grounding spring is in contact with the camera assembly. In some embodiments, the camera bracket includes a first positioning block and a second positioning block that are fixedly connected, the first positioning block is disposed closer to the camera assembly than the second positioning block, and second accommodating space is formed between the first positioning block and the second positioning block; and
the body part and the first bending part of the grounding spring are disposed in the second accommodating space, the second positioning block includes a first side surface and a second side surface that are perpendicular to each other, the first side surface is disposed parallel to the body part, and the second side surface is directly connected to a surface on a side that is of the grounding part and that is close to the body part.

In some embodiments, a first clamping groove is disposed on the first positioning block of the camera bracket;
the second bending part includes: a first contact subpart and a second contact subpart;
the second contact is disposed on the first contact subpart, a first buckle is disposed on a side that is of the second contact subpart and that is close to the first bending part, and the first buckle is configured to be clamped to the first clamping groove;
at least one second clamping groove is disposed on the second positioning block of the camera bracket; and
the first bending part includes a first bending section and a second bending section that are connected to each other, at least one second buckle is disposed on a side that is of the body part and that is away from the second bending section, and each second buckle is configured to be clamped to one second clamping groove.

The embodiments of this application achieve the following beneficial effects:
According to the grounding spring and the electronic device provided in the embodiments of this application, the grounding spring is applied to the electronic device, and the grounding spring is configured to connect a grounding area and a camera assembly in the electronic device, so that the camera assembly is grounded. The grounding spring includes the body part and the grounding part. One side of the body part is fixedly connected to the grounding part, and the other side is bent in the direction close to the grounding part to form the first bending part. The side that is of the first bending part and that is close to the grounding part is bent in the direction away from the grounding part to form the second bending part. The first contact subpart of the second bending part is directly connected to the camera assembly, so that the camera assembly is connected to the grounding area by using the grounding spring. The first accommodating space is formed between the first bending part and the second bending part, and the partial structure of the camera bracket is disposed in the first accommodating space, so that the grounding spring is mounted on the camera bracket. **In** the grounding spring provided in the embodiments of this application, the body part is located between the grounding part and the first contact subpart. When the grounding spring is mounted in the electronic device, the grounding part is directly connected to the grounding area, and the first contact subpart is directly connected to the camera assembly. **In** a direction perpendicular to the grounding area, that is, in the thickness direction of the electronic device, a distance between the grounding part and the first contact subpart is a sum of a size of the first contact subpart, a size of the body part, and a size of the grounding part in the thickness direction of the electronic device. Therefore, the distance between the grounding part and the first contact subpart is increased when the body part is disposed in the grounding spring, and an increased distance is approximately the size of the body part in the thickness direction of the electronic device. The body part makes the distance between the grounding part and the first contact subpart relatively large, so that the grounding spring can be applied to an electronic device in which a distance between a camera assembly and a grounding area is relatively large.

Certainly, any product or method for implementing this application unnecessarily needs to simultaneously achieve all the foregoing advantages. The foregoing description is merely an overview of the technical solutions in this application. To understand the technical means in this application more clearly, the technical means may be implemented based on the content of the specification. In addition, to make the foregoing and other objectives, features, and advantages of this application clearer and easier to understand, specific implementations of this application are enumerated below.

### BRIEF DESCRIPTION OF DRAWINGS

To describe the technical solutions in the embodiments of this application or in the conventional technology more clearly, the following briefly describes the accompanying drawings required for describing the embodiments or the conventional technology. Clearly, the accompanying drawings in the following description show merely some embodiments of this application, and persons of ordinary skill in the art may still derive other embodiments from these accompanying drawings without creative efforts.
FIG. 1 is a diagram of a structure of a grounding spring according to some embodiments of this application;
FIG. 2 is a diagram of a structure obtained when a grounding spring is mounted in an electronic device according to some embodiments of this application;
FIG. 3 is a diagram of a partial structure of a grounding spring according to some embodiments of this application;
FIG. 4 is a side view obtained when a grounding spring is mounted in an electronic device according to some embodiments of this application;
FIG. 5 is a top view obtained when a grounding spring is mounted in an electronic device according to some embodiments of this application; and
FIG. 6 is a diagram of a partial structure of a grounding spring according to some embodiments of this application.

### DESCRIPTION OF EMBODIMENTS

The following describes in detail embodiments of the technical solutions in this application with reference to the accompanying drawings. The following embodiments are merely used to describe the technical solutions in this application more clearly. Therefore, the following embodiments are merely used as examples, and are not intended to limit the protection scope of this application.

Unless otherwise defined, all technical and scientific terms used in this specification have the same meanings as those commonly understood by persons skilled in the technical field of this application. The terms used in this specification are merely intended to describe specific embodiments, and are not intended to limit this application. The terms "including", "having", and any variant thereof in the specification, the claims, and the foregoing accompanying drawings in this application are intended to cover non-exclusive inclusion.

In the description of the embodiments of this application, the technical terms such as "first" and "second" are merely used to distinguish between different objects, and should not be understood as an indication or an implication of relative importance or an implicit indication of a quantity or a specific sequence of indicated technical features or a primary-secondary relationship between the indicated technical features. In the description of the embodiments of this application, unless otherwise specifically defined, "a plurality of" means two or more.

The "embodiment" mentioned in this specification means that a specific feature, structure, or characteristic described with reference to the embodiment may be included in at least one embodiment of this application. The term appearing at various locations in this specification does not necessarily refer to a same embodiment, or an independent or alternative embodiment mutually exclusive with another embodiment. Persons skilled in the art explicitly and implicitly understand that the embodiments described in this specification may be combined with other embodiments. In the description of the embodiments of this application, the term "and/or" is merely used to describe an association relationship between associated objects, and represents that three relationships may exist. For example, "A and/or B" may represent the following three cases: Only A exists, both A and B exist, and only B exists. In addition, the character "/" in this specification usually represents an "or" relationship between associated objects.

In the description of the embodiments of this application, the term "a plurality of" means at least two (including two). Similarly, "a plurality of groups" means at least two groups (including two groups), and "a plurality of pieces" means at least two pieces (including two pieces).

In the description of the embodiments of this application, orientation or location relationships indicated by the technical terms such as "center", "longitudinal", "lateral", "length", "width", "thickness", "up", "down", "front", "rear", "left", "right", "vertical", "horizontal", "top", "bottom", "inner", "outer", "clockwise", "counterclockwise", "axial", "radial", and "circumferential" are orientation or location relationships shown based on the accompanying drawings, and are merely intended for convenience of describing the embodiments of this application and simplifying the description, rather than indicating or implying that the indicated apparatus or element needs to have a particular orientation and be constructed and operated in a particular orientation, and therefore should not be understood as a limitation on the embodiments of this application.

In the description of the embodiments of this application, unless otherwise specified and defined explicitly, technical terms such as "mount", "connected", "connect", and "fasten" should be understood in a broad sense, for example, may be a fixed connection, a detachable connection, or an integrated connection; may be a mechanical connection or an electrical connection; may be a direct connection or an indirect connection implemented through an intermediate medium; or may be an internal communication between two elements or an interaction relationship between two elements. Persons of ordinary skill in the art may understand specific meanings of the foregoing terms in the embodiments of this application based on a specific situation.

Currently, a photographing function of an electronic device such as a mobile phone or a tablet has become a key selling point of the electronic device, and a camera assembly is an important component for implementing the photographing function of the electronic device. During working, electrical signal interference is generated between the camera assembly and another electronic element inside the electronic device, which affects photographing quality of the camera assembly. To resolve the foregoing problem, a grounding spring is often disposed in the electronic device, and the grounding spring is configured to connect the camera assembly to a grounding area in the electronic device, to implement grounding of the camera assembly, thereby reducing signal interference between the camera assembly and another electronic element, and improving an anti-interference capability of the camera assembly. **In** a related technology, the grounding spring includes a first contact and a second contact, the first contact is directly connected to a camera body of the camera assembly, and the second contact is directly connected to the grounding area. **In** the grounding spring in the related technology, a distance between the first contact and the second contact is relatively small in a direction perpendicular to the grounding area. For example, the distance between the first contact and the second contact is less than or equal to 1.6 mm in the direction perpendicular to the grounding area. Therefore, the grounding spring can be applied only to an electronic device in which a relatively small quantity of electronic elements exist between the camera assembly and the grounding area and a distance between the camera assembly and the grounding area is relatively small, and there is no grounding spring applicable to an electronic device in which a relatively large quantity of electronic elements exist between the camera assembly and the grounding area and a distance between the camera assembly and the grounding area is relatively large.

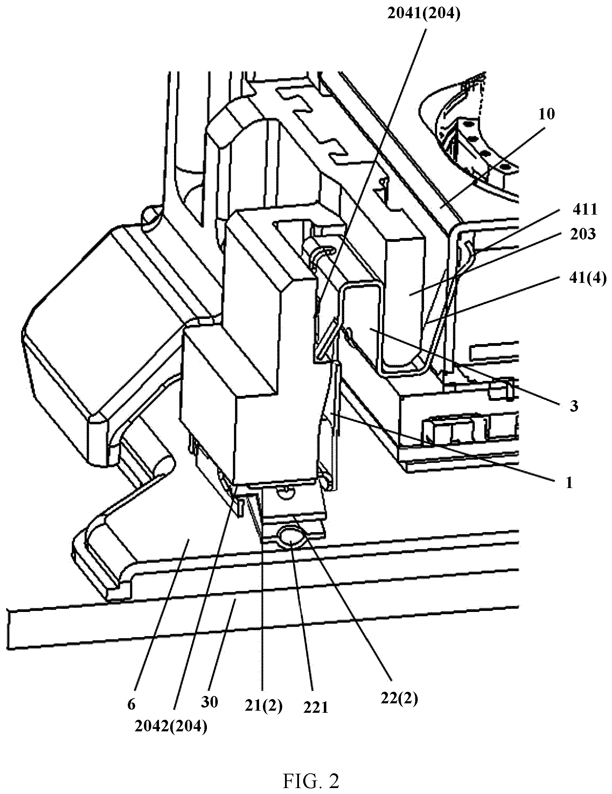

To provide a grounding spring that can be applied to an electronic device in which a distance between a camera assembly and a grounding area is relatively large, embodiments of this application provide a grounding spring and an electronic device. With reference to the accompanying drawings, the following describes in detail the grounding spring and the electronic device provided in the embodiments of this application. The grounding spring may be applied to an electronic device with a camera assembly, such as a mobile phone, a tablet, or a computer. As shown in FIG. 2, the electronic device includes a camera assembly 10, a camera bracket 20 configured to mount the camera assembly 10, and a main board 30. The main board 30 has a grounding area. The grounding area may be an area formed by a metal plate integrated into the main board 30, or the grounding area may be a metal area formed through exposure of a surface of the main board 30.

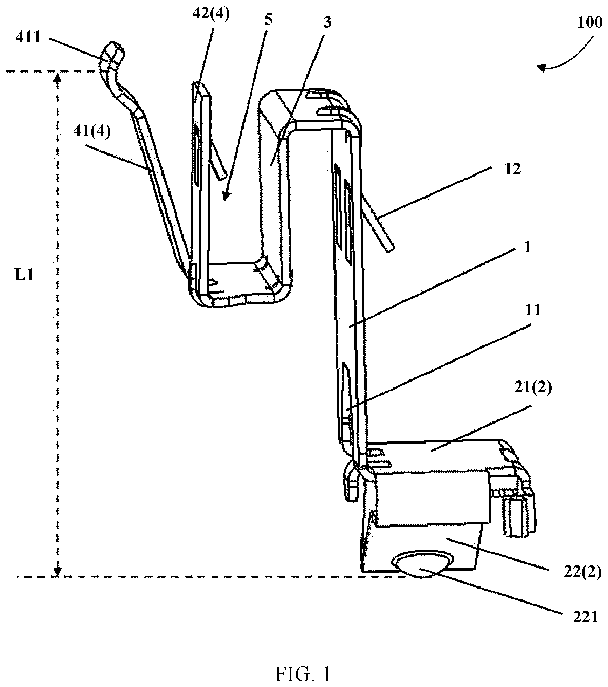

As shown in FIG. 1, an embodiment in a first aspect of this application provides a grounding spring 100. The grounding spring 100 includes a body part 1 and a grounding part 2. The grounding part 2 is located on one side of the body part 1 and is fixedly connected to the body part 1. A side that is of the grounding part 2 and that is away from the body part 1 is connected to the grounding area. A side that is of the body part 1 and that is away from the grounding part 2 is bent in a direction close to the grounding part 2 to form a first bending part 3, and a side that is of the first bending part 3 and that is close to the grounding part 2 is bent in a direction away from the grounding part 2 to form a second bending part 4. First accommodating space 5 is formed between the first bending part 3 and the second bending part 4, and the first accommodating space 5 is configured to accommodate a partial structure of a camera bracket 20. The second bending part 4 includes a first contact subpart 41, and the first contact subpart 41 is configured to be directly connected to a camera assembly 10.

In this embodiment of this application, for ease of description, when the grounding spring 100 is mounted in an electronic device, the following is defined: A direction facing the camera assembly 10 is "up", and a direction facing a main board 30 is "down". A material of the grounding spring 100 is metal such as copper or aluminum or an alloy having metal such as copper or aluminum. As shown in FIG. 1, the body part 1 may be in a sheet-like structure, and the body part 1 is roughly rectangular. The first bending part 3 and the grounding part 2 are respectively disposed on two sides of the body part 1 in a length direction. Optionally, when the grounding spring 100 is mounted in an electronic device, the body part 1 is disposed perpendicular to the grounding area on the main board 30. Therefore, in a direction perpendicular to the grounding area, the body part 1 causes a specific distance between the first bending part 3 and the grounding part 2 on the two sides of the body part 1. In addition, because the second bending part 4 is formed by bending a lower side of the first bending part 3 upward, the body part 1 causes a specific distance between the first contact subpart 41 on the second bending part 4 and the grounding part 2. The camera assembly 10 includes a camera body and a housing configured to accommodate the camera body. That the first contact subpart 41 is directly connected to the camera assembly may be as follows: The first contact subpart 41 passes through the housing to be directly connected to or abut against the camera body, or the first contact subpart 41 is directly connected to or abuts against a conductive area on the housing.

The first accommodating space 5 is formed between the first bending part 3 and the second bending part 4, and when the grounding spring 100 is mounted in an electronic device, the partial structure of the camera bracket 20 is located in the first accommodating space 5, so that the grounding spring 100 can be mounted on the camera bracket 20. Optionally, as shown in FIG. 1, a partial structure of the first bending part 3 may be disposed parallel to the body part 1. Optionally, the first bending part 3, the second bending part 4, the body part 1, and the grounding part 2 may be in an integrated structure. The first bending part 3 may be formed by bending an upper side of the body part 1 through stamping, the grounding part 2 may be formed by bending a lower side of the body part 1 through stamping, and the second bending part 4 may be formed by bending the lower side of the first bending part 3 through stamping.

In the grounding spring 100 provided in this embodiment of this application, the body part 1 is located between the grounding part 2 and the first contact subpart 41. When the grounding spring 100 is mounted in an electronic device, the grounding part 2 is directly connected to the grounding area, and the first contact subpart 41 is directly connected to the camera assembly 10. In a direction perpendicular to the grounding area, that is, in a thickness direction of the electronic device, a distance between the grounding part 2 and the first contact subpart 41 is a sum of a size of the first contact subpart 41, a size of the body part 1, and a size of the grounding part 2 in the thickness direction of the electronic device. Therefore, the distance between the grounding part 2 and the first contact subpart 41 is increased when the body part 1 is disposed in the grounding spring 100, and an increased distance is approximately the size of the body part 1 in the thickness direction of the electronic device. As shown in FIG. 1, there is a first distance L1 between a contact end of the first contact subpart 41 and a contact end of the grounding part 2. Therefore, when the grounding spring 100 is applied to an electronic device, the grounding spring 100 may be applied to an electronic device in which a distance between the camera assembly 10 and the grounding area is approximately L1, so that the grounding spring 100 can be applied to an electronic device in which a distance between the camera assembly 10 and the grounding area is relatively large.

In some embodiments, as shown in FIG. 1, the grounding part 2 includes a fastening subpart 21 and an elastic subpart 22 connected to the fastening subpart 21. The fastening subpart 21 is connected to the body part 1. A first contact 221 is disposed on the elastic subpart 22, and the first contact 221 is configured to connect to the grounding area. The elastic subpart 22 may move in a direction close to or away from the fastening subpart 21.

In this embodiment of this application, as shown in FIG. 1, the first contact 221 is located on a lower surface of the elastic subpart 22, and the first contact 221 may be a protrusion protruding from the lower surface of the elastic subpart 22. The elastic subpart 22 and the fastening subpart 21 each may be in a sheet-like structure. As shown in FIG. 1, elastic deformation space is formed between the elastic subpart 22 and the fastening subpart 21. When the elastic subpart 22 is subjected to upward force, the elastic subpart 22 may move in a direction close to the fastening subpart 21 and is in a compressed state. After the force is removed, the elastic subpart 22 may be reset through rebound force of the elastic subpart 22. Through disposing of the elastic subpart 22, when the grounding spring 100 is mounted, the elastic subpart 22 may be in a slightly compressed state, and then the elastic subpart 22 presses the grounding area below tightly through the rebound force of the elastic subpart 22, so that the first contact 221 is stably connected to the grounding area.

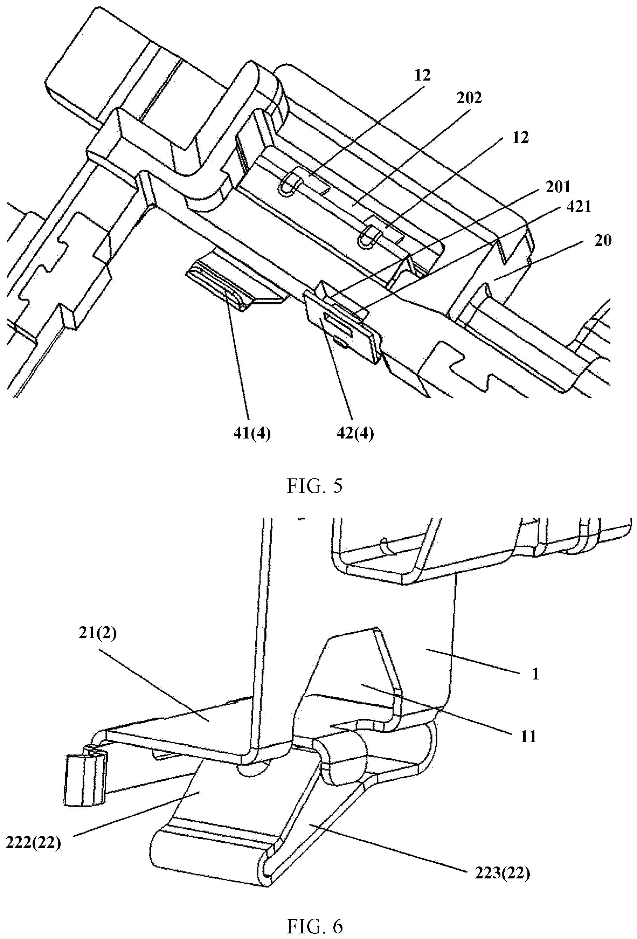

Optionally, the elastic subpart 22 and the fastening subpart 21 may also be in an integrated structure. Optionally, as shown in FIG. 6, FIG. 6 is a schematic diagram of a structure of the grounding part 2. The elastic subpart 22 includes a first subpart 222 and a second subpart 223 that are integrally connected. The first subpart 222 is disposed closer to the fastening subpart 21 than the second subpart 223, and the first contact 221 is disposed on a lower surface of the second subpart 223. Elastic deformation space is formed between the first subpart 222 and the second subpart 223.

As shown in FIG. 6, when the grounding spring 100 is in a natural state, the first subpart 222 and the second subpart 223 are disposed obliquely relative to the fastening subpart 21. The first subpart 222 and the second subpart 223 are elastic and can be elastically deformed. When the elastic subpart 22 is connected to the grounding area, one end of the second subpart 223 is first in contact with the grounding area and is disposed at a specific included angle with the grounding area. Then, pressure is applied to the grounding spring 100, and the second subpart 223 and the first subpart 222 are deformed under action of the pressure, so that an included angle between the grounding area and each of the second subpart 223 and the first subpart 222 gradually decreases, until the second subpart 223 and the first subpart 222 are approximately parallel to the grounding area, and the first contact 221 is in contact with the grounding area. When the grounding spring 100 is in the natural state, the first subpart 222 and the second subpart 223 are disposed obliquely relative to the fastening subpart 21. Therefore, when the grounding spring 100 is mounted in an electronic device, the first subpart 222 and the second subpart 223 are elastically deformed, and the elastic subpart 22 presses the grounding area below tightly through rebound force of the first subpart 222 and the second subpart 223, so that the first contact 221 is stably connected to the grounding area. In some embodiments, as shown in FIG. 2, the grounding spring 100 may further include a lap member 6, and the lap member 6 is disposed between the grounding area and the grounding part 2 of the grounding spring 100. The lap member 6 is in a conductive structure. One side of the lap member 6 is directly connected to the grounding area, and the other side is directly connected to the first contact 221 of the grounding part 2, to implement grounding of the grounding part 2. The lap member 6 is configured to further increase a size of the grounding spring 100 in a thickness direction, so that the grounding spring 100 can be applied to an electronic device in which a distance between the camera assembly 10 and the grounding area is relatively large.

In some embodiments, the fastening subpart 21 is disposed perpendicular to the body part 1. As shown in FIG. 1 and FIG. 2, the fastening subpart 21 is disposed perpendicular to the body part 1, and unclosed third accommodating space is formed between the fastening subpart 21 and the body part 1. The camera bracket 20 includes a first positioning block 203 and a second positioning block 204. Second accommodating space is defined between the first positioning block 203 and the second positioning block 204. As shown in FIG. 2, when the grounding spring 100 is mounted in an electronic device, the body part 1 and the first bending part 3 of the grounding spring 100 are located in the second accommodating space, and the second positioning block 204 is located in the unclosed third accommodating space. A lower surface of the second positioning block 204 is disposed opposite to or directly connected to an upper surface of the fastening subpart 21, and a side surface that is of the second positioning block 204 and that is adjacent to the lower surface and perpendicular to the lower surface is disposed corresponding to or directly connected to a side surface of the body part 1. The fastening subpart 21 is disposed perpendicular to the body part 1, so that the fastening subpart 21 and the body part 1 better cooperate with the lower surface and the side surface of the second positioning block 204, and the grounding spring 100 is more stably mounted on the camera bracket 20.

In some embodiments, as shown in FIG. 1, the first contact subpart 41 includes a second contact 411, and the second contact 411 is directly connected to the camera assembly 10. In the direction perpendicular to the grounding area, a distance L1 between the first contact 221 and the second contact 411 is greater than 1.6 mm.

In this embodiment of this application, for ease of description, the following distances all are distances in the direction perpendicular to the grounding area. The distance L1 between the first contact 221 and the second contact 411 is greater than 1.6 mm, so that when the grounding spring 100 is mounted in an electronic device, a distance between the camera assembly 10 directly connected to the second contact 411 and the grounding area in contact with the first contact 221 can be greater than 1.6 mm. In other words, the grounding spring 100 can be applied to an electronic device in which a distance between the camera assembly 10 and the grounding area is greater than 1.6 mm. The distance L1 between the first contact 221 and the second contact 411 is related to a size in a direction of a long edge of the body part 1, that is, related to a length of the body part 1. Therefore, the length of the body part 1 may be changed to adjust the distance between the first contact 221 and the second contact 411, so that the grounding spring 100 can be applied to electronic devices of a plurality of sizes.

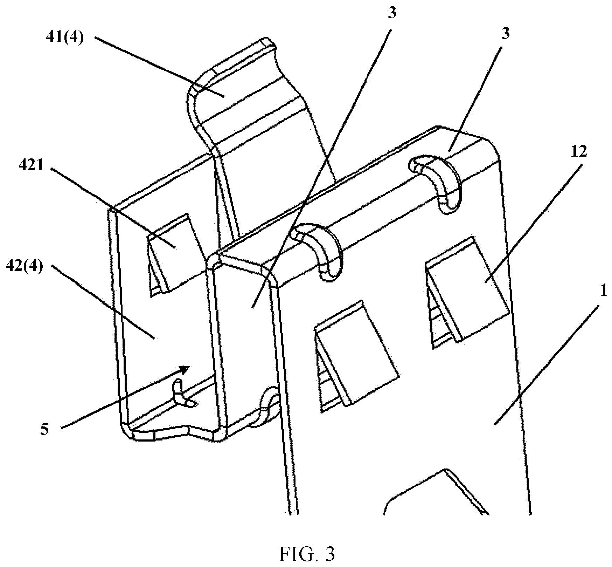

In some embodiments, as shown in FIG. 3 and FIG. 5, a first clamping groove 201 is disposed on the camera bracket 20. The second bending part 4 further includes a second contact subpart 42. A first buckle 421 is disposed on a side that is of the second contact subpart 42 and that is close to the first bending part 3, and the first buckle 421 is configured to be clamped to the first clamping groove 201.

In this embodiment of this application, as shown in FIG. 1 and FIG. 3, the second bending part 4 further includes the second contact subpart 42, and the second contact subpart 42 is configured to connect to the camera bracket 20 to fasten the grounding spring 100. Optionally, as shown in FIG. 1 and FIG. 3, the second contact subpart 42 may be disposed parallel to the first bending part 3, so that the second contact subpart 42 is connected to the camera bracket. Optionally, as shown in FIG. 1, the first contact subpart 41 and the second contact subpart 42 are located on different planes. An upper end of the first contact subpart 41 is disposed obliquely in a direction away from the first bending part 3, and the second contact 411 is disposed at the upper end of the first contact subpart 41, so that the second contact 411 is directly connected to the camera assembly 10. The first buckle 421 is disposed on the side that is of the second contact subpart 42 and that is close to the first bending part 3. When the grounding spring 100 is mounted in an electronic device, the first buckle 421 is clamped to the first clamping groove 201 on the camera bracket 20. The first buckle 421 and the first clamping groove 201 are configured to limit the grounding spring 100, to reduce a probability that the grounding spring 100 rotates relative to the camera bracket 20 due to reaction force of the camera assembly 10, so that the grounding spring 100 can be directly connected to the camera assembly 10 and the grounding area more stably.

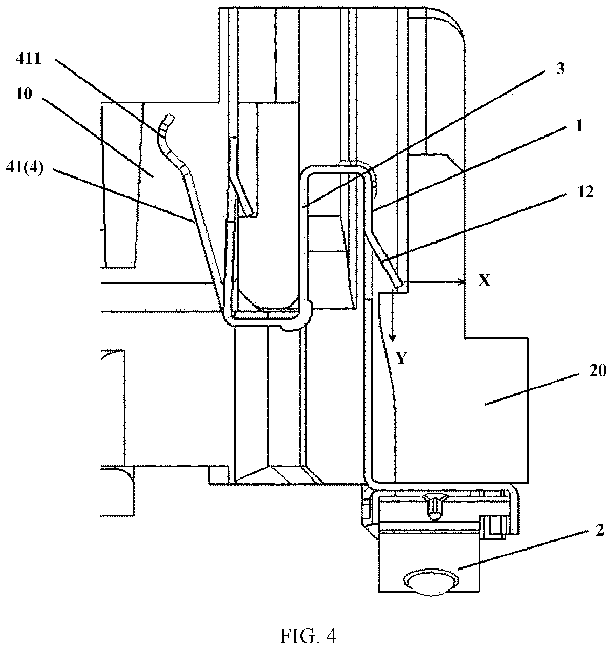

Optionally, as shown in FIG. 3 and FIG. 4, the first buckle 421 is in a sheet-like structure, and the first buckle 421 is disposed obliquely downward relative to the second contact subpart 42. The first buckle 421 is disposed obliquely downward, so that when the first buckle 421 is clamped to the first clamping groove 201, the first buckle 421 may apply downward pressure to the camera bracket 20 in a vertical direction, so that the first buckle 421 can fasten the grounding spring 100 in the direction perpendicular to the grounding area. The first buckle 421 may further apply pressure to the camera bracket 20 in a horizontal direction, thereby reducing a probability that the grounding spring 100 rotates relative to the camera bracket 20.

Optionally, the first buckle 421 and the second bending part 4 may be in an integrated structure. For example, the first buckle 421 may be obtained by stamping a partial area of the second bending part 4.

In some embodiments, as shown in FIG. 3 and FIG. 5, at least one second clamping groove 202 is disposed on the camera bracket 20. At least one second buckle 12 is disposed on a side that is of the body part 1 and that is close to the first bending part 3, and each second buckle 12 is configured to be clamped to one second clamping groove 202.

In this embodiment of this application, when the grounding spring 100 is mounted in an electronic device, the second buckle 12 is clamped to the second clamping groove 202 on the camera bracket 20. The second buckle 12 and the second clamping groove 202 are configured to limit the grounding spring 100, to reduce a probability that the grounding spring 100 rotates relative to the camera bracket 20 due to reaction force of the camera assembly 10, and further increase connection stability between the grounding spring 100 and each of the camera assembly 10 and the grounding area.

Optionally, as shown in FIG. 4 and FIG. 5, the second buckle 12 is in a sheet-like structure, and the second buckle 12 is disposed obliquely downward relative to the body part 1. The second buckle 12 is disposed obliquely downward, so that when the second buckle 12 is clamped to the second clamping groove 202, the second buckle 12 may apply downward pressure to the camera bracket 20 in a vertical direction Y, so that the second buckle 12 can fasten the grounding spring in the direction perpendicular to the grounding area. The second buckle 12 may further apply rightward pressure in FIG. 4 to the camera bracket 20 in a horizontal direction X, thereby reducing a probability that the grounding spring rotates relative to the camera bracket 20. A quantity of second buckles 12 and a quantity of second clamping grooves 202 may be set based on an actual requirement, and each second buckle 12 is clamped to one second clamping groove 202.

Optionally, the second buckle 12 and the first bending part 3 may be in an integrated structure. For example, the second buckle 12 may be obtained by stamping a partial area of the first bending part 3.

In some embodiments, as shown in FIG. 3, two second buckles 12 are disposed on a side that is of the body part 1 and that is away from the first bending part 3. Correspondingly, two second clamping grooves 202 are disposed on the camera bracket 20. When the grounding spring 100 is mounted in an electronic device, each second buckle 12 is clamped to one second clamping groove 202. The two second buckles 12 jointly limit the grounding spring 100, to further reduce a probability that the grounding spring rotates relative to the camera bracket 20, and further increase connection stability between the grounding spring 100 and each of the camera assembly 10 and the grounding area.

Optionally, as shown in FIG. 3, the two second buckles 12 are disposed side by side in a wide edge direction of the body part 1.

In some embodiments, a first through hole 11 is provided on the body part 1, and the first through hole 11 extends to the fastening subpart 21. The first through hole 11 is a craft hole, and is configured to: when the lower side of the body part 1 is bent to form the fastening subpart 21, reduce bending difficulty of the body part 1, and reduce a probability that a fracture occurs at a joint of the body part 1 and the fastening subpart 21 due to stress concentration.

An embodiment in a second aspect of this application provides an electronic device. The electronic device includes a camera assembly 10, a camera bracket 20, a main board 30, and the grounding spring 100 in any one of the foregoing embodiments. The camera bracket 20 is configured to mount the camera assembly 10, and the main board 30 has a grounding area. The grounding spring 100 is connected to the camera bracket 20, the first contact subpart 41 of the second bending part 4 of the grounding spring 100 is directly connected to the camera assembly 10, and the grounding part 2 of the grounding spring 100 is connected to the grounding area.

In this embodiment of this application, the electronic device includes but is not limited to a device having a camera assembly, such as a mobile phone, a tablet, or a notebook computer. In the grounding spring 100 included in the electronic device provided in this embodiment of this application, the body part 1 is located between the grounding part 2 and the first contact subpart 41. When the grounding spring 100 is mounted in the electronic device, the grounding part 2 is directly connected to the grounding area, and the first contact subpart 41 is directly connected to the camera assembly 10. In a direction perpendicular to the grounding area, that is, in a thickness direction of the electronic device, a distance between the grounding part 2 and the first contact subpart 41 is a sum of a size of the first contact subpart 41, a size of the body part 1, and a size of the grounding part 2 in the thickness direction of the electronic device. Therefore, the distance between the grounding part 2 and the first contact subpart 41 is increased when the body part 1 is disposed in the grounding spring 100, and an increased distance is approximately the size of the body part 1 in the thickness direction of the electronic device. As shown in FIG. 1, there is a first distance L1 between a contact end of the first contact subpart 41 and a contact end of the grounding part 2. Therefore, when the grounding spring 100 is applied to an electronic device, the grounding spring 100 may be applied to an electronic device in which a distance between the camera assembly 10 and the grounding area is approximately L1, so that the grounding spring 100 can be applied to an electronic device in which a distance between the camera assembly 10 and the grounding area is relatively large.

In some embodiments, as shown in FIG. 2, the camera bracket 20 includes a first positioning block 203 and a second positioning block 204 that are fixedly connected, the first positioning block 203 is disposed closer to the camera assembly 10 than the second positioning block 204, and second accommodating space is formed between the first positioning block 203 and the second positioning block 204. The body part 1 and the first bending part 3 of the grounding spring 100 are disposed in the second accommodating space, the second positioning block 204 includes a first side surface 2041 and a second side surface 2042 that are perpendicular to each other, the first side surface 2041 is disposed parallel to the body part 1, and the second side surface 2042 is disposed parallel to a surface on a side that is of the grounding part 2 and that is close to the body part 1.

In this embodiment of this application, the first side surface 2041 of the second positioning block 204 may be a lower surface of the second positioning block 204, and the second side surface 2042 is a side surface that is adjacent to the lower surface and perpendicular to the lower surface. Unclosed accommodating space is formed between the fastening subpart 21 and the body part 1, and the second accommodating space is defined between the first positioning block 203 and the second positioning block 204. The body part 1 and the first bending part 3 of the grounding spring 100 are located in the second accommodating space, and the second positioning block 204 is located in the unclosed accommodating space. The lower surface of the second positioning block 204 is disposed opposite to or directly connected to an upper surface of the grounding part 2, and the side surface of the second positioning block 204 is disposed corresponding to or directly connected to a side surface of the body part 1, so that the grounding spring 100 is more stably mounted on the camera bracket 20.

Finally, it should be noted that, the foregoing embodiments are merely used to describe the technical solutions in this application, but are not intended to constitute limitations on the technical solutions in this application. Although this application is described in detail with reference to the foregoing embodiments, persons of ordinary skill in the art should understand that, they may still make modifications to the technical solutions described in the foregoing embodiments or make equivalent replacements to some or all technical features thereof, without departing from the scope of the technical solutions in the embodiments of this application. All of the modifications or replacements shall fall within the scope of the claims and the specification of this application. In particular, as long as no structural conflict exists, the technical features mentioned in the embodiments may be combined in any manner. This application is not limited to the specific embodiments disclosed herein, but includes all technical solutions falling within the scope of the claims.

## Claims

1. A grounding spring (100), applied to an electronic device, wherein the electronic device comprises a camera assembly (10), a camera bracket (20) configured to mount the camera assembly (10), and a circuit board (30), the circuit board (30) has a grounding area, and the grounding spring (100) comprises:
a body part (1); and
a grounding part (2), wherein the grounding part (2) is located on one side of the body part (1) and is fixedly connected to the body part (1), a first contact (221) is disposed on the grounding part (2), and the first contact (221) is configured to be in contact with the grounding area, wherein
a side that is of the body part (1) and that is away from the grounding part (2) is bent to form a first bending part (3) extending in a direction towards the grounding part (2), and is bent at an end that is of the first bending part (3) and that is close to the grounding part (2) to form a second bending part (4) extending in a direction away from the grounding part (2),
a first accommodating space (5) is formed between the first bending part (3) and the second bending part (4), the first accommodating space (5) is configured to accommodate a partial structure of the camera bracket (20), a second contact (411) is disposed on the second bending part (4), and the second contact (411) is configured to be in contact with the camera assembly (10).

2. The grounding spring (100) according to claim 1, wherein
the grounding part (2) comprises a fastening subpart (21) and an elastic subpart (22) connected to the fastening subpart (21), the fastening subpart (21) is connected to the body part (1), the first contact (221) is disposed on the elastic subpart (22), and the elastic subpart (22) may move in a direction close to or away from the fastening subpart (21).

3. The grounding spring (100) according to claim 2, wherein the elastic subpart (22) comprises:
a first subpart (222) and a second subpart (223) that are integrally connected, wherein the first subpart (222) is disposed closer to the fastening subpart (21) than the second subpart (223), the first contact (221) is disposed on a lower surface of the second subpart (223), and elastic deformation space is formed between the first subpart (222) and the second subpart (223).

4. The grounding spring (100) according to claim 3, wherein the body part (1) is in a sheet-like structure, and a length direction of the sheet-like structure is consistent with a thickness direction of the electronic device;
the grounding part (2) is located at a first end that is of the body part (1) and that is in the thickness direction of the electronic device, and the first bending part (3) is located at a second end that is of the body part (1) and that is in the thickness direction of the electronic device; and
the fastening subpart (21) is formed by laterally bending the first end of the body part (1), so that the fastening subpart (21) is perpendicular to the body part (1).

5. The grounding spring (100) according to claim 1, wherein
a first clamping groove (201) is disposed on the camera bracket (20);
the second bending part (4) comprises: a first contact subpart (41) and a second contact subpart (42); and
the second contact (411) is disposed on the first contact subpart (41), a first buckle (421) is disposed on a side that is of the second contact subpart (42) and that is close to the first bending part (3), and the first buckle (421) is configured to be clamped to the first clamping groove (201).

6. The grounding spring (100) according to claim 5, wherein the body part (1) is in a sheet-like structure, and the grounding part (2) and both of the first bending part (3) and the second bending part (4) are respectively located on two sides of the sheet-like structure in a length direction.

7. The grounding spring (100) according to claim 6, wherein
the first bending part (3) comprises a first bending section and a second bending section that are connected to each other; the first bending section is formed by laterally bending the side that is of the body part (1) and that is away from the grounding part (2); and the second bending section is formed by bending, in the direction close to the grounding part (2), an end that is of the first bending section and that is away from the body part (1);
the second bending part (4) comprises a third bending section and a fourth bending section that are connected to each other; the third bending section is formed by laterally bending, in a direction away from the body part (1), an end that is of the second bending section and that is away from the first bending section; the fourth bending section is formed by bending, in the direction away from the grounding part (2), an end that is of the third bending section and that is away from the second bending section; and the second contact (411) is disposed on the fourth bending section; and
the second bending section, the third bending section, and the fourth bending section form the first accommodating space (5).

8. The grounding spring (100) according to claim 7, wherein the first contact subpart (41) belongs to the fourth bending section, and the second contact (411) is located at an end of the fourth bending section and that is away from the third bending section.

9. The grounding spring (100) according to claim 8, wherein the second contact subpart (42) belongs to the fourth bending section, and the first contact subpart (41) and the second contact subpart (42) are separated from each other, and are both fixedly connected to the third bending section; and
the first buckle (421) is disposed on a side of the second contact subpart (42) and that is close to the second bending section.

10. The grounding spring (100) according to claim 1, wherein at least one second clamping groove (202) is disposed on the camera bracket (20); and
at least one second buckle (12) is disposed on a side that is of the body part (1) and that is away from the second bending part (4), and each second buckle (12) is configured to be clamped to one second clamping groove (202).

11. The grounding spring (100) according to claim 2, wherein a first through hole (11) is provided on the body part (1), and the first through hole (11) extends to the fastening subpart (21); and
a second through hole is provided at each of a joint of the body part (1) and the first bending part (3), a joint of the first bending part (3) and the second bending part (4), and a bending location of the second bending part (4).

12. The grounding spring (100) according to any one of claims 1-11, wherein a distance between the first contact (221) and the second contact (411) in the thickness direction of the electronic device is greater than 1.6 mm.

13. An electronic device, comprising a camera assembly (10), a camera bracket (20), a circuit board (30), and the grounding spring (100) according to any one of claims 1-12, wherein the camera bracket (20) is configured to mount the camera assembly (10), and the circuit board (30) has a grounding area; and
the grounding spring (100) is connected to the camera bracket (20), the first contact (221) on the grounding part (2) of the grounding spring (100) is in contact with the grounding area on the circuit board (30), and the second contact (411) on the second bending part (4) of the grounding spring (100) is in contact with the camera assembly (10).

14. The electronic device according to claim 13, wherein the camera bracket (20) comprises a first positioning block (203) and a second positioning block (204) that are fixedly connected, the first positioning block (203) is disposed closer to the camera assembly (10) than the second positioning block (204), and second accommodating space is formed between the first positioning block (203) and the second positioning block (204); and
the body part (1) and the first bending part (3) of the grounding spring (100) are disposed in the second accommodating space, the second positioning block (204) comprises a first side surface and a second side surface that are perpendicular to each other, the first side surface is disposed parallel to the body part (1), and the second side surface is directly connected to a surface on a side that is of the grounding part (2) and that is close to the body part (1).

15. The electronic device according to claim 14, wherein
a first clamping groove (201) is disposed on the first positioning block (203) of the camera bracket (20);
the second bending part (4) comprises: a first contact subpart (41) and a second contact subpart (42);
the second contact (411) is disposed on the first contact subpart (41), a first buckle (421) is disposed on a side that is of the second contact subpart (42) and that is close to the first bending part (3), and the first buckle (421) is configured to be clamped to the first clamping groove (201);
at least one second clamping groove (202) is disposed on the second positioning block (204) of the camera bracket (20); and
the first bending part (3) comprises a first bending section and a second bending section that are connected to each other, at least one second buckle (12) is disposed on a side that is of the body part (1) and that is away from the second bending section, and each second buckle (12) is configured to be clamped to one second clamping groove (202).

## Patentansprüche

1. Eine Erdungsfeder (100), die auf ein elektronisches Gerät angewendet wird, wobei das elektronische Gerät eine Kameraeinheit (10), eine Kamerahalterung (20), welche dazu eingerichtet ist, die Kameraeinheit (10) zu montieren, und eine Leiterplatte (30) umfasst, wobei die Leiterplatte (30) eine Erdungsfläche aufweist und die Erdungsfeder (100) folgendes umfasst:
einen Grundkörper (1); und
ein Erdungsteil (2), wobei sich das Erdungsteil (2) auf einer Seite des Grundkörpers (1) befindet und fest mit dem Grundkörper (1) verbunden ist, ein erster Kontakt (221) im Erdungsteil (2) vorgesehen ist und der erste Kontakt (221) dazu eingerichtet ist, mit der Erdungsfläche in Kontakt zu stehen, wobei
eine dem Erdungsteil (2) abgewandte Seite des Grundkörpers (1) gebogen ist, um einen ersten Biegebereich (3) zu bilden, der in Richtung auf das Erdungsteil (2) verläuft, und an einem Ende des ersten Biegebereichs (3), das dem Erdungsteil (2) nahe ist, ein zweiter Biegebereich (4) gebildet wird, der in eine Richtung weg vom Erdungsteil (2) verläuft,
ein erster Aufnahmeraum (5) wird zwischen dem ersten Biegebereich (3) und dem zweiten Biegebereich (4) gebildet, der erste Aufnahmeraum (5) ist dazu eingerichtet, eine Teilstruktur der Kamerahalterung (20) aufzunehmen, ein zweiter Kontakt (411) ist auf dem zweiten Biegebereich (4) angebracht und der zweite Kontakt (411) ist dazu eingerichtet, mit der Kameraeinheit (10) in Kontakt zu stehen.

2. Die Erdungsfeder (100) gemäß Anspruch 1, wobei
das Erdungsteil (2) ein Befestigungsunterteil (21) und ein elastisches Unterteil (22), das mit dem Befestigungsunterteil (21) verbunden ist, umfasst, wobei das Befestigungsunterteil (21) mit dem Grundkörper (1) verbunden ist, der erste Kontakt (221) auf dem elastischen Unterteil (22) angebracht ist und das elastische Unterteil (22) sich in eine Richtung zu oder von dem Befestigungsunterteil (21) bewegen kann.

3. Die Erdungsfeder (100) gemäß Anspruch 2, wobei das elastische Unterteil (22) umfasst:
ein erstes Unterteil (222) und ein zweites Unterteil (223), die integrativ miteinander verbunden sind, wobei das erste Unterteil (222) näher am Befestigungsunterteil (21) angeordnet ist als das zweite Unterteil (223), der erste Kontakt (221) auf einer unteren Oberfläche des zweiten Unterteils (223) angebracht ist und zwischen dem ersten Unterteil (222) und dem zweiten Unterteil (223) ein elastischer Verformungsraum gebildet wird.

4. Die Erdungsfeder (100) gemäß Anspruch 3, wobei der Grundkörper (1) eine plattenförmige Struktur aufweist und die Längsrichtung der plattenförmigen Struktur mit der Dickenrichtung des elektronischen Geräts übereinstimmt;
Der Erdungsteil (2) befindet sich an einem ersten Ende des Grundkörpers (1), das in der Dickenrichtung des elektronischen Geräts liegt, und der erste Biegeteil (3) befindet sich an einem zweiten Ende des Grundkörpers (1), das ebenfalls in der Dickenrichtung des elektronischen Geräts liegt; und
Der Befestigungsunterteil (21) wird gebildet, indem das erste Ende des Grundkörpers (1) seitlich gebogen wird, sodass der Befestigungsunterteil (21) senkrecht zum Grundkörper (1) steht.

5. Die Erdungsfeder (100) gemäß Anspruch 1, wobei
eine erste Klemmnut (201) auf der Kamerahalterung (20) angeordnet ist;
der zweite Biegeteil (4) umfasst: einen ersten Kontaktunterteil (41) und einen zweiten Kontaktunterteil (42); und
Der zweite Kontakt (411) ist am ersten Kontaktunterteil (41) angeordnet, eine erste Schnalle (421) ist an einer Seite des zweiten Kontaktunterteils (42) nahe dem ersten Biegeteil (3) angeordnet, und die erste Schnalle (421) ist dafür vorgesehen, in die erste Klemmnut (201) eingeklemmt zu werden.

6. Die Erdungsfeder (100) gemäß Anspruch 5, wobei der Grundkörper (1) eine plattenartige Struktur aufweist und der Erdungsteil (2) sowie sowohl der erste Biegeteil (3) als auch der zweite Biegeteil (4) jeweils an den beiden Seiten der plattenartigen Struktur in Längsrichtung angeordnet sind.

7. Die Erdungsfeder (100) gemäß Anspruch 6, wobei
der erste Biegeteil (3) umfasst einen ersten Biegebereich und einen zweiten Biegebereich, die miteinander verbunden sind; der erste Biegebereich entsteht durch seitliches Biegen der Seite des Grundkörpers (1), die vom Erdungsteil (2) entfernt ist; der zweite Biegebereich entsteht durch Biegen des Endes des ersten Biegebereichs, das vom Grundkörper (1) entfernt ist, in Richtung auf den Erdungsteil (2);
der zweite Biegeteil (4) umfasst einen dritten Biegebereich und einen vierten Biegebereich, die miteinander verbunden sind; der dritte Biegebereich entsteht durch seitliches Biegen des Endes des zweiten Biegebereichs, das vom ersten Biegebereich entfernt ist, in eine Richtung weg vom Grundkörper (1); der vierte Biegebereich entsteht durch Biegen des Endes des dritten Biegebereichs, das vom zweiten Biegebereich entfernt ist, in Richtung weg vom Erdungsteil (2); und der zweite Kontakt (411) befindet sich am vierten Biegebereich; und
der zweite Biegebereich, der dritte Biegebereich und der vierte Biegebereich bilden den ersten Aufnahmeraum (5).

8. Die Erdungsfeder (100) gemäß Anspruch 7, wobei der erste Kontaktunterteil (41) zum vierten Biegebereich gehört und der zweite Kontakt (411) sich an einem Ende des vierten Biegebereichs befindet, das vom dritten Biegebereich entfernt liegt.

9. Die Erdungsfeder (100) gemäß Anspruch 8, wobei der zweite Kontaktunterteil (42) zum vierten Biegebereich gehört und der erste Kontaktunterteil (41) sowie der zweite Kontaktunterteil (42) voneinander getrennt sind und beide fest mit dem dritten Biegebereich verbunden sind; und
die erste Schnalle (421) befindet sich an einer Seite des zweiten Kontaktunterteils (42), die dem zweiten Biegebereich nahe ist.

10. Die Erdungsfeder (100) gemäß Anspruch 1, wobei mindestens eine zweite Klemmnut (202) auf der Kamerahalterung (20) angeordnet ist; und
mindestens eine zweite Schnalle (12) befindet sich an einer Seite des Körperteils (1), die vom zweiten Biegeteil (4) entfernt ist, und jede zweite Schnalle (12) ist dazu vorgesehen, in einer zweiten Klemmnut (202) gehalten zu werden.

11. Die Erdungsfeder (100) gemäß Anspruch 2, wobei ein erstes Durchgangsloch (11) am Körperteil (1) vorgesehen ist und sich das erste Durchgangsloch (11) bis zum Befestigungsunterteil (21) erstreckt; und
an jedem Verbindungspunkt des Körperteils (1) mit dem ersten Biegeteil (3), des ersten Biegeteils (3) mit dem zweiten Biegeteil (4) und an einer Biegelocation des zweiten Biegeteils (4) ist ein zweites Durchgangsloch vorgesehen.

12. Die Erdungsfeder (100) gemäß einem der Ansprüche 1-11, wobei der Abstand zwischen dem ersten Kontakt (221) und dem zweiten Kontakt (411) in Dickenrichtung des elektronischen Geräts größer als 1,6 mm ist.

13. Ein elektronisches Gerät, das eine Kameraeinheit (10), eine Kamerahalterung (20), eine Leiterplatte (30) und die Erdungsfeder (100) gemäß einem der Ansprüche 1-12 umfasst, wobei die Kamerahalterung (20) für die Montage der Kameraeinheit (10) vorgesehen ist und die Leiterplatte (30) einen Erdungsbereich aufweist; und
die Erdungsfeder (100) ist mit der Kamerahalterung (20) verbunden, der erste Kontakt (221) am Erdungsteil (2) der Erdungsfeder (100) steht mit dem Erdungsbereich der Leiterplatte (30) in Kontakt, und der zweite Kontakt (411) am zweiten Biegeteil (4) der Erdungsfeder (100) steht mit der Kameraeinheit (10) in Kontakt.

14. Elektronisches Gerät gemäß Anspruch 13, wobei die Kamerahalterung (20) einen ersten Positionierungsblock (203) und einen zweiten Positionierungsblock (204) umfasst, die fest miteinander verbunden sind, wobei der erste Positionierungsblock (203) näher an der Kameraeinheit (10) als der zweite Positionierungsblock (204) angeordnet ist, und zwischen dem ersten Positionierungsblock (203) und dem zweiten Positionierungsblock (204) ein zweiter Aufnahmebereich gebildet ist; und
der Körperteil (1) und der erste Biegeteil (3) der Erdungsfeder (100) sind im zweiten Aufnahmebereich angeordnet, der zweite Positionierungsblock (204) umfasst eine erste Seitenfläche und eine zweite Seitenfläche, die senkrecht zueinander stehen, wobei die erste Seitenfläche parallel zum Körperteil (1) angeordnet ist und die zweite Seitenfläche direkt mit einer Fläche auf einer Seite verbunden ist, die dem Erdungsteil (2) zugeordnet ist und die zum Körperteil (1) zeigt.

15. Elektronisches Gerät gemäß Anspruch 14, wobei
eine erste Klemmnut (201) am ersten Positionierungsblock (203) der Kamerahalterung (20) vorgesehen ist;
der zweite Biegeteil (4) umfasst: einen ersten Kontaktunterabschnitt (41) und einen zweiten Kontaktunterabschnitt (42);
der zweite Kontakt (411) befindet sich am ersten Kontaktunterabschnitt (41), eine erste Schnalle (421) befindet sich auf der dem zweiten Kontaktunterabschnitt (42) zugeordneten und dem ersten Biegeteil (3) nahen Seite, und die erste Schnalle (421) ist vorgesehen, in die erste Klemmnut (201) geklemmt zu werden;
mindestens eine zweite Klemmnut (202) ist am zweiten Positionierungsblock (204) der Kamerahalterung (20) vorgesehen; und
der erste Biegeteil (3) umfasst einen ersten Biegebereich und einen zweiten Biegebereich, die miteinander verbunden sind; auf der vom zweiten Biegebereich entfernten Seite des Körperteils (1) ist mindestens eine zweite Schnalle (12) angeordnet, und jede zweite Schnalle (12) ist dazu vorgesehen, in eine zweite Klemmnut (202) geklemmt zu werden.

## Revendications

1. Un ressort de mise à la terre (100) destiné à être appliqué à un dispositif électronique, ledit dispositif électronique comprenant un ensemble caméra (10), un support de caméra (20) conçu pour monter l'ensemble caméra (10), et une carte de circuit imprimé (30), la carte de circuit imprimé (30) ayant une zone de mise à la terre, et le ressort de mise à la terre (100) comprenant :
une partie principale (1) ; et
une partie de mise à la terre (2), la partie de mise à la terre (2) étant située sur un côté de la partie principale (1) et étant fixée de façon permanente à celle-ci, un premier contact (221) étant disposé sur la partie de mise à la terre (2) et le premier contact (221) étant destiné à entrer en contact avec la zone de mise à la terre, dans laquelle
un côté de la partie principale (1) opposé à la partie de mise à la terre (2) est plié pour former une première partie de courbure (3) s'étendant vers la partie de mise à la terre (2), et est replié à une extrémité de la première partie de courbure (3) proche de la partie de mise à la terre (2) pour former une deuxième partie de courbure (4) s'étendant dans une direction opposée à la partie de mise à la terre (2),
un premier espace d'accueil (5) est formé entre la première partie de courbure (3) et la deuxième partie de courbure (4), le premier espace d'accueil (5) étant conçu pour accueillir une structure partielle du support de caméra (20), un second contact (411) étant disposé sur la deuxième partie de courbure (4), et le second contact (411) étant destiné à entrer en contact avec l'ensemble caméra (10).

2. Le ressort de mise à la terre (100) selon la revendication 1, dans lequel
la partie de mise à la terre (2) comprend une sous-partie de fixation (21) et une sous-partie élastique (22) reliée à la sous-partie de fixation (21), la sous-partie de fixation (21) étant connectée à la partie principale (1), le premier contact (221) étant disposé sur la sous-partie élastique (22), et la sous-partie élastique (22) pouvant se déplacer dans une direction proche ou éloignée de la sous-partie de fixation (21).

3. Le ressort de mise à la terre (100) selon la revendication 2, dans lequel la sous-partie élastique (22) comprend :
une première sous-partie (222) et une deuxième sous-partie (223) qui sont reliées de manière intégrale, la première sous-partie (222) étant disposée plus près de la sous-partie de fixation (21) que la deuxième sous-partie (223), le premier contact (221) étant disposé sur une surface inférieure de la deuxième sous-partie (223), un espace de déformation élastique étant formé entre la première sous-partie (222) et la deuxième sous-partie (223).

4. Le ressort de mise à la terre (100) selon la revendication 3, dans lequel la partie principale (1) présente une structure en forme de feuille, et la direction de la longueur de cette structure en forme de feuille correspond à la direction de l'épaisseur du dispositif électronique ;
la partie de mise à la terre (2) est située à une première extrémité de la partie principale (1) et dans la direction de l'épaisseur du dispositif électronique, et la première partie courbée (3) est située à une seconde extrémité de la partie principale (1) et dans la direction de l'épaisseur du dispositif électronique ; et
la sous-partie de fixation (21) est formée par le pliage latéral de la première extrémité de la partie principale (1), de sorte que la sous-partie de fixation (21) soit perpendiculaire à la partie principale (1).

5. Le ressort de mise à la terre (100) selon la revendication 1, dans lequel
une première rainure de serrage (201) est disposée sur le support de caméra (20) ;
la seconde partie courbée (4) comprend : une première sous-partie de contact (41) et une seconde sous-partie de contact (42) ; et
le second contact (411) est disposé sur la première sous-partie de contact (41), un premier ergot (421) est disposé sur un côté de la seconde sous-partie de contact (42) et qui est proche de la première partie courbée (3), et le premier ergot (421) est conçu pour être fixé dans la première rainure de serrage (201).

6. Le ressort de mise à la terre (100) selon la revendication 5, où la partie principale (1) présente une structure en forme de plaque, et la partie de mise à la terre (2) ainsi que la première partie courbée (3) et la seconde partie courbée (4) sont respectivement situées de chaque côté de la structure en forme de plaque dans la direction de la longueur.

7. Le ressort de mise à la terre (100) selon la revendication 6, dans lequel
la première partie courbée (3) comprend une première section courbée et une seconde section courbée qui sont reliées entre elles ; la première section courbée est formée par un pliage latéral du côté de la partie principale (1) qui est éloignée de la partie de mise à la terre (2) ; et la seconde section courbée est formée par pliage, dans la direction proche de la partie de mise à la terre (2), d'une extrémité de la première section courbée qui est opposée à la partie principale (1) ;
la seconde partie courbée (4) comprend une troisième section courbée et une quatrième section courbée qui sont reliées entre elles ; la troisième section courbée est formée par un pliage latéral, dans une direction éloignée de la partie principale (1), d'une extrémité de la seconde section courbée qui est opposée à la première section courbée ; la quatrième section courbée est formée par un pli dans la direction opposée à la partie de mise à la terre (2), d'une extrémité de la troisième section courbée qui est opposée à la seconde section courbée ; et le second contact (411) est disposé sur la quatrième section courbée ; et
la seconde section courbée, la troisième section courbée, et la quatrième section courbée forment le premier espace d'accueil (5).

8. Le ressort de mise à la terre (100) selon la revendication 7, dans lequel la première sous-partie de contact (41) appartient à la quatrième section de pliage, et le second contact (411) est situé à une extrémité de la quatrième section de pliage qui est éloignée de la troisième section de pliage.

9. Le ressort de mise à la terre (100) selon la revendication 8, dans lequel la deuxième sous-partie de contact (42) appartient à la quatrième section de pliage, et la première sous-partie de contact (41) et la deuxième sous-partie de contact (42) sont séparées l'une de l'autre, et sont toutes deux raccordées de manière fixe à la troisième section de pliage ; et
la première attache (421) est disposée sur un côté de la seconde sous-partie de contact (42), qui est proche de la deuxième section de pliage.

10. Le ressort de mise à la terre (100) selon la revendication 1, dans lequel au moins une seconde rainure de serrage (202) est disposée sur le support de caméra (20) ; et
au moins une seconde attache (12) est disposée sur un côté de la partie principale (1) et qui est éloignée de la seconde partie pliée (4), et chaque seconde attache (12) est conçue pour être fixée dans une seconde rainure de serrage (202).

11. Le ressort de mise à la terre (100) selon la revendication 2, dans lequel un premier trou traversant (11) est prévu sur la partie principale (1), et le premier trou traversant (11) s'étend jusqu'à la sous-partie de fixation (21) ; et
un deuxième trou traversant est prévu à chaque jonction entre la partie principale (1) et la première partie pliée (3), entre la première partie pliée (3) et la deuxième partie pliée (4), et à l'emplacement courbé de la deuxième partie pliée (4).

12. Le ressort de mise à la terre (100) selon l'une quelconque des revendications 1 à 11, dans lequel la distance entre le premier contact (221) et le second contact (411) dans la direction de l'épaisseur de l'appareil électronique est supérieure à 1,6 mm.

13. Un dispositif électronique, comprenant un ensemble caméra (10), un support de caméra (20), une carte de circuit imprimé (30), et le ressort de mise à la terre (100) selon l'une quelconque des revendications 1 à 12, dans lequel le support de caméra (20) est conçu pour monter l'ensemble caméra (10), et la carte de circuit imprimé (30) comporte une zone de mise à la terre ; et
le ressort de mise à la terre (100) est connecté au support de caméra (20), le premier contact (221) sur la partie de mise à la terre (2) du ressort de mise à la terre (100) est en contact avec la zone de mise à la terre sur la carte de circuit imprimé (30), et le second contact (411) sur la deuxième partie pliée (4) du ressort de mise à la terre (100) est en contact avec l'ensemble caméra (10).

14. Dispositif électronique selon la revendication 13, dans lequel le support de caméra (20) comprend un premier bloc de positionnement (203) et un second bloc de positionnement (204) reliés de manière fixe, le premier bloc de positionnement (203) étant disposé plus près de l'ensemble caméra (10) que le second bloc de positionnement (204), et un deuxième espace de réception est formé entre le premier bloc de positionnement (203) et le second bloc de positionnement (204) ; et
la partie principale (1) et la première partie de courbure (3) du ressort de mise à la terre (100) sont disposés dans le deuxième espace de réception, le second bloc de positionnement (204) comprenant une première surface latérale et une seconde surface latérale perpendiculaires l'une à l'autre, la première surface latérale étant disposée parallèlement à la partie principale (1), et la seconde surface latérale étant directement reliée à une surface latérale de la partie de mise à la terre (2) proche de la partie principale (1).

15. Dispositif électronique selon la revendication 14, dans lequel
une première rainure de fixation (201) est disposée sur le premier bloc de positionnement (203) du support de caméra (20) ;
la seconde partie de courbure (4) comprend : une première sous-partie de contact (41) et une seconde sous-partie de contact (42) ;
le second contact (411) est disposé sur la première sous-partie de contact (41), une première agrafe (421) est disposée sur un côté de la seconde sous-partie de contact (42), proche de la première partie de courbure (3), et la première agrafe (421) est conçue pour être fixée dans la première rainure de fixation (201) ;
au moins une seconde rainure de fixation (202) est disposée sur le second bloc de positionnement (204) du support de caméra (20) ; et
la première partie de courbure (3) comprend une première section de courbure et une seconde section de courbure reliées entre elles, au moins une seconde agrafe (12) est disposée sur un côté de la partie principale (1) opposé à la seconde section de courbure, et chaque seconde agrafe (12) est conçue pour être fixée dans une seconde rainure de fixation (202).
